# EUROPEAN PATENT SPECIFICATION

(11) **EP 1 756 327 B1**
(45) Date of publication and mention of the grant of the patent: **17.12.2008**
(21) Application number: 05747126.0
(22) Date of filing: 03.06.2005
(51) Int. Cl.: C23C 14/58, C23C 14/34, C01G 7/00

(54) **METHODS OF MAKING GOLD NITRIDE**
VERFAHREN ZUR HERSTELLUNG VON GOLDNITRID
PROCEDES DE FABRICATION DE NITRURE D'OR

(30) Priority: 10.06.2004 GB 0413036
(43) Date of publication of application: 28.02.2007
(73) Proprietor: THE UNIVERSITY OF NEWCASTLE UPON TYNE, Newcastle Upon Tyne NE1 7RU (GB)
(72) Inventor: Siller, Lidija, Whitley Bay NE26 2AT (GB); Krishnamurthy, Satheesh, Dublin - 8 (IE); Chao, Yimin, Newcastle NE5 4DG (GB)
(74) Representative: Watson, Robert James
(86) International application number: PCT/GB2005/002197
(87) International publication number: WO 2005/121395

(56) References cited:
- SILLER L ET AL: "Nitrogen ion irradiation of Au(110): formation of gold nitride" SURFACE SCIENCE ELSEVIER NETHERLANDS, vol. 513, no. 1, 10 July 2002 (2002-07-10), pages 78-82, XP002339558 ISSN: 0039-6028 cited in the application
- SANGHERA H K ET AL: "Study of low energy high dose nitrogen implantation in aluminum, iron, copper and gold" SURF INTERFACE ANAL; SURFACE AND INTERFACE ANALYSIS 1999 JOHN WILEY & SONS LTD, CHICHESTER, ENGL, vol. 27, no. 7, 1999, pages 678-690, XP009052028
- ZHOU X ET AL: "FORMATION OF NOBLE-METAL NITRIDES BY NITROGEN IMPLANTATION" NUCLEAR INSTRUMENTS & METHODS IN PHYSICS RESEARCH, SECTION - B: BEAM INTERACTIONS WITH MATERIALS AND ATOMS, NORTH-HOLLAND PUBLISHING COMPANY, AMSTERDAM, NL, vol. B39, no. 1 - 4 INDEX, 2 March 1989 (1989-03-02), pages 583-586, XP000050421 ISSN: 0168-583X

## Description

This invention relates to methods of making gold nitride.

Gold is widely used in a number of industries including electronics, instrumentation in the biological sciences, as an essential part of medical diagnostic devices, etc. It is an expensive commodity and limited as an earth resource. In industrial applications, gold is often applied as a thin film applied to less expensive substrates, however often there is a limitation as to the minimum thickness of such a film as gold is a soft metal and easily abraded. Various methods have been found for increasing the gold film's hardness by alloying it with other metals, and whilst these methods suffice, the gold still represents a significant expense to industry. The current invention relates to methods of forming gold nitride in particular as part of a gold film which preferably seek to significantly increase the hardness of the gold film and so allow much thinner layers of gold to be used, thereby potentially yielding significant economic benefits to industry.

The physical properties of electroplated gold films are known to be influenced by incorporated impurities or inclusions, as well as by extraneous materials on the surface of the gold film. In electrodepositing methods, a granular structure is known to occur and is believed to be a reason for the rapid wear of electrodeposited gold films. It is thought that gold nitride will be a harder wearing surface, with many potential applications.

The only successful attempt at forming gold nitride in the literature is a paper co-authored by one of the present inventors ( 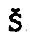 iller, L., et al., Surf. Sci., 513, 78-82 (2002)), which used nitrogen ion irradiation under ultra-high vacuum conditions. The presence of gold nitride as a result of this method was demonstrated by the use of high resolution X-ray photoemission spectroscopy to determine N1s core level spectra. However, the process described in this paper is unsuitable for scaling to industrially useful levels of production as it requires an ultra-high vacuum which is difficult and costly to achieve.

The present inventors have developed a method for the formation of gold nitride. This method involves the treatment of a gold thin film with a nitrogen plasma that has been generated by a radio frequency field ("a nitrogen radio frequency plasma") and which has been generated with a power less than or equal to 500 W.

The radio frequencies to generate the plasma are between 10 and 17 MHz. A particularly preferred radio frequency for generating the nitrogen plasma is 13.56 MHz.

This method avoids the need for an ultra-high vacuum, and can be carried out using commercially available apparatus.

Accordingly, a first aspect of the present invention provides a method of treating a gold film to produce gold nitride, comprising the step of subjecting a gold film to a radio-frequency nitrogen plasma generated with a power of less than or equal to 500 W.

Preferably the gold film is a thin film, i.e. a film having a thickness of up to 10 µm, although a thickness of 2 µm or less is more preferred. Preferably the film is supported on an appropriate substrate. The thickness of the film of gold nitride produced by this method is likely to be somewhat less than the thickness of the original film, due to removal of surface layers by plasma etching. The gold film may in particular be deposited on a substrate, for example a silicon wafer, by using a standard sputter coating system.

Accordingly, a second aspect of the present invention provides a method of making a film of gold nitride, comprising the steps of:
a) sputter coating a substrate to form a gold film; and
b) subjecting the gold film to a radio-frequency nitrogen plasma generated with a power of less than or equal to 500 W.

Using a greater power to generate the radio-frequency nitrogen plasma would destroy the gold nitride surface as it is formed. The power used to generate the radio-frequency nitrogen plasma is less than or equal to 500 W and is most preferably less than or equal to 300 W and may be possibly less than or equal to about 100 W. It has been found that a plasma generated with a power of about 300 W produces the most gold nitride per cycle of plasma treatment, due to a more favourable ratio between N⁺ (and/or N⁺⁺) and N₂⁺ ions in the plasma, N⁺/N⁺⁺ being preferred to N₂⁺ ions.

The gold film is biased so as to achieve directional attack of the nitrogen plasma. The voltage used to bias the sample is less than or equal to 1000 V, more preferably less than 700 V, and is most preferably less than or equal to 500 V. It is thought that a lower biasing voltage prevents removal of the gold nitride being formed by excessive plasma etching. One convenient device which can be used to carry out the method of the invention is an etching machine. These are usually employed to produce high powered plasma, but can be adapted to generate the plasmas required by the present invention and also have the facility to bias the sample plate.

One stoichiometry of the gold nitride produced by the present methods is Au₃N.

A further aspect of the present invention provides gold nitride obtainable by or obtained by the methods of the previous aspects, including any combination of the preferred or optional features of those aspects.

Embodiments of the present invention will now be described by way of example, and with reference to the following figures, in which:
Fig. 1 shows the photoemission spectrum of the gold nitride film of Example 1;
Fig. 2 shows photoemission spectra of gold nitride films synthesised by the ion implantation method of the prior art ( 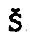 iller, L., *et al.,* Surf. Sci., 513, 78-82 (2002));

### Example 1

A gold film 1 to 2 µm thick was deposited on a standard 100 mm wafer using a sputter coating system (Science technology systems (STS), machine type: BOC Edwards Sputter system). The gold nitride was then formed by exposing the gold film to plasma generated by a radio frequency field. The power employed to generate plasma was 300 W and the target was biased to -240 V. The nitrogen pressure in the plasma chamber was 0.85 Pa (6.4 mTorr), and the flow rate of N₂ was 50 sccm (cubic centimeter per second). The plasma was generated by radio frequency at 13.56 MHz and the growth time was about thirty minutes, which is the length of the plasma treatment. The manual automatic pressure controller (APC) angle of the system was set to 91°.

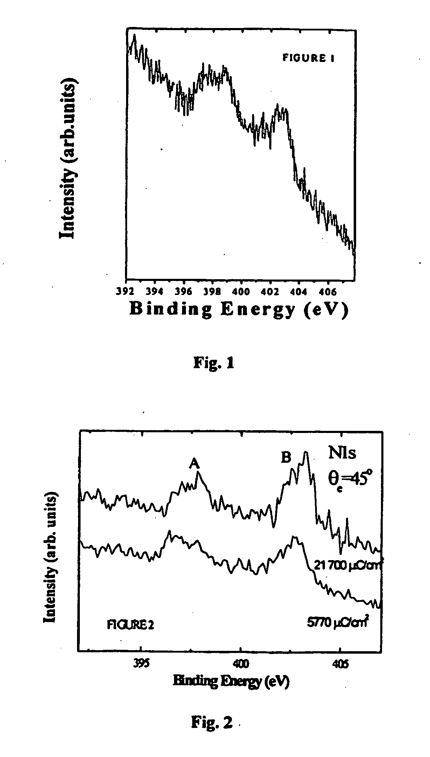

The photoemission spectrum of the material produced is presented in Fig. 1, taken at the National Centre for Electron Spectroscopy and Surface Analysis (NCESS), Daresbury Laboratory, Warrington, United Kingdom with a monochromatic X-ray source and an ESCA 300 analyser, which was used for all the spectra presented herein.

Photoemission spectra of the Nls core level spectra obtained from an Au (110) surface exposed to a nitrogen ion dose of 5770 µC/cm² and 21 700 µC/cm² at 500 eV and at room temperature, according to the method described in 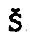 iller, L., *et al.,* Surf. Sci., 513, 78-82 (2002) are shown in Fig. 2. Peaks A in these spectra are attributed to the gold-nitride and peaks B to nitrogen bubble formation in gold. The shape and the position of the peaks in both Figs. 1 and 2 are almost identical, leading to the conclusion that the plasma treatment of the present invention also results in the formation of gold nitride.

### Example 2

The method of Example 1 was repeated, but generating the radio-frequency plasma using a power of 100 W, and biasing the target at between -200 and -310 V.

## Claims

1. A method of treating a gold film to form gold nitride including the steps of:
generating a nitrogen plasma with a radio frequency field between 10 and 17 MHz and a power of less than or equal to 500W;
biasing the gold film with a bias voltage which is less than or equal to 1 kV; and
treating said gold film with said nitrogen plasma.

2. A method according to claim 1, wherein the gold film has a thickness of less than 2 µm.

3. A method according to either claim 1 or claim 2 wherein the power used to generate said nitrogen plasma is less than or equal to 300W.

4. A method according to any one of the preceding claims wherein the bias voltage is less than or equal to 500 V.

5. A method according to any one of the preceding claims which is carried out in an etching machine.

## Patentansprüche

1. Verfahren zur Behandlung eines Goldfilms zur Bildung von Goldnitrid, umfassend folgende Schritte:
die Bildung eines Stickstoffplasmas mit einem Hochfrequenzfeld zwischen 10 und 17 MHz und einer Leistung von weniger als oder gleich 500 W;
Vorspannen des Goldfilms mit einer Vorspannung von weniger als oder gleich 1 kV; und
die Behandlung des Goldfilms mit dem Stickstoffplasma.

2. Verfahren nach Anspruch 1, worin der Goldfilm eine Dicke von weniger als 2 µm aufweist.

3. Verfahren nach einem der Ansprüche 1 oder 2, worin die zur Bildung des Stickstoffplasmas eingesetzte Leistung weniger als oder gleich 300 W beträgt.

4. Verfahren nach einem der vorangegangenen Ansprüche, worin die Vorspannung weniger als oder gleich 500 V beträgt.

5. Verfahren nach einem der vorangegangenen Ansprüche, das in einer Ätzmaschine durchgeführt wird.

## Revendications

1. Procédé de traitement d'un film d'or pour former du nitrure d'or comprenant les étapes consistant à:
produire un plasma d'azote avec un champ radiofréquence entre 10 et 17 MHz et une puissance inférieure ou égale à 500W;
polariser le film d'or avec une tension de polarisation qui est inférieure ou égale à 1 kV; et
traiter ledit film d'or avec ledit plasma d'azote.

2. Procédé selon la revendication 1, où le film d'or a une épaisseur inférieure à 2 µm.

3. Procédé selon la revendication 1 ou la revendication 2, où la puissance utilisée pour produire ledit plasma d'azote est inférieure ou égale à 300W.

4. Procédé selon l'une des revendications précédentes, où la tension de polarisation est inférieure ou égale à 500 V.

5. Procédé selon l'une des revendications précédentes, qui est exécuté dans une machine à graver.
